# EUROPEAN PATENT APPLICATION

(11) **EP 4 830 549 A1**
(43) Date of publication of application: **28.10.2026**
(21) Application number: 25227555.7
(22) Date of filing: 30.12.2025
(51) Int. Cl.: A24F 40/40, A24F 40/60

(54) **DISPLAY MODULE OF ATOMIZATION DEVICE, AND ATOMIZATION DEVICE**

(30) Priority: 21.04.2025 CN 202520761817 U
(71) Applicant: Shenzhen Geekvape Technology Co., Ltd., Shenzhen, Guangdong 518100 (CN)
(72) Inventor: LIAO, Huaping, Shenzhen, 518100 (CN)
(74) Representative: Manitz Finsterwald Patent- und Rechtsanwaltspartnerschaft mbB

(57) **Abstract**

The present disclosure relates to the technical field of electronic atomization, and discloses a display module of an atomization device, and an atomization device. The display module includes a housing, a circuit board, a display screen, and a connector, where the circuit board is disposed in the housing, and the circuit board is provided with a first electrical connection structure. The display screen is disposed inside the housing or outside the housing. The connector is disposed on the display screen and electrically connected to the display screen. The connector has a second electrical connection structure, and the second electrical connection structure is detachably connected to the first electrical connection structure. The connector of the present disclosure, the display screen, and the circuit board are connected and installed in a simple, convenient manner, thereby reducing costs.

## Description

### CROSS-REFERENCE TO RELATED APPLICATION

The present application claims priority to the Chinese Patent Application No.: 2025207618174 filed on April 21, 2025, and the entirety of the afore-mentioned patent application is hereby incorporated by reference herein.

### TECHNICAL FIELD

The present disclosure relates to the technical field of electronic atomization, and particularly relates to a display module of an atomization device, and an atomization device.

### BACKGROUND

To enhance the user experience and facilitate a user in promptly obtaining a current usage state of an atomization device, a display screen is usually disposed in the atomization device to display a battery level, liquid volume, operating state, and some other animations of the atomization device. In the prior art, a display screen is usually connected to a circuit board via an FPC cable or by soldering, and the FPC cable is used to connect the display screen and the circuit board, which usually occupies excessive space. Moreover, connecting the cable to the display screen and the circuit board respectively is required, resulting in that operation steps are cumbersome, while the connection by soldering increases the difficulty of processing. Therefore, both connection methods in the prior art increase costs.

### SUMMARY

The present disclosure provides a display module of an atomization device, and an atomization device, and a connector in the display module is configured to connect a circuit board and a display screen, thereby reducing operation steps and costs.

According to a first aspect of the present disclosure, a display module of an atomization device is provided, including: a housing; a circuit board disposed in the housing, where the circuit board is provided with a first electrical connection structure; a display screen disposed inside the housing or outside the housing; and a connector disposed on the display screen and electrically connected to the display screen; and the connector has a second electrical connection structure, and the second electrical connection structure is detachably connected to the first electrical connection structure.

In an embodiment, the connector is provided with a clamping space having an installation opening, the second electrical connection structure is disposed in the clamping space, and a portion of the circuit board provided with the first electrical connection structure is assembled into the clamping space through the installation opening, such that the second electrical connection structure is electrically connected to the first electrical connection structure, and the second electrical connection structure elastically abuts against the first electrical connection structure to clamp the circuit board in the clamping space.

In an embodiment, the installation opening is disposed on a side of the connector facing away from the display screen, and the circuit board is arranged perpendicular to the display screen.

In an embodiment, the circuit board is provided with a clearance groove, a side wall of the clearance groove is provided with a first snap-fit structure, an outer side wall of the clamping space is provided with a second snap-fit structure, a side wall of the clamping space extends into the clearance groove, and the second snap-fit structure cooperates with the first snap-fit structure to further fixedly connect the circuit board and the display screen.

In an embodiment, the first snap-fit structure includes a snap-fit groove, and the second snap-fit structure includes a snap-fit clasp, where the snap-fit clasp has elasticity, thereby allowing the snap-fit clasp to easily extend into or disengage from the snap-fit groove; and the second snap-fit structure includes a snap-fit groove, and the first snap-fit structure includes a snap-fit clasp, where the snap-fit clasp has elasticity, thereby allowing the snap-fit clasp to easily extend into or disengage from the snap-fit groove.

In an embodiment, at least two clearance grooves are formed, at least one first snap-fit structure is disposed in each of the clearance grooves, and the second snap-fit structures are arranged in one-to-one correspondence with the first snap-fit structures.

In an embodiment, elastic second electrical connection structures are respectively disposed on opposite inner sides of the clamping space, and the second electrical connection structures elastically abut against the first electrical connection structures to clamp and fix the circuit board in the clamping space.

In an embodiment, the display screen is disposed on an outer side wall of the housing, the outer side wall of the housing is provided with a connection port penetrating through the outer side wall of the housing, and the connector is electrically connected to circuit board through the connection port.

In an embodiment, a mounting groove is concavely disposed on the outer side wall of the housing, and the display screen is disposed in the mounting groove.

In an embodiment, an adhesive layer is disposed on a portion of the outer side wall of the housing, and the adhesive layer is located between the mounting groove and the display screen and configured to adhesively fix the display screen.

In a second aspect of the present disclosure, an atomization device is provided, including an atomizer and the above display module, the atomizer is electrically connected to the display module, and the display module is configured to display a liquid volume and operating state of the atomizer.

The present disclosure provides a display module of an atomization device, and an atomization device, and the display module includes a housing, a circuit board, a display screen, and a connector, where the circuit board is provided with a first electrical connection structure, the connector is disposed on the display screen, the second electrical connection structure is disposed on the connector, and an electrical connection between the display screen and the circuit board is achieved through a detachable connection between the second electrical connection structure and the first electrical connection structure. The connector of the present disclosure, the display screen, and the circuit board are connected and installed in a simple, convenient manner, thereby reducing costs.

### BRIEF DESCRIPTION OF DRAWINGS

FIG. 1 is a schematic structural diagram of a display module of an atomization device according to Embodiment 1 or Embodiment 2.
FIG. 2 is a schematic diagram of an exploded structure of the display module of an atomization device shown in FIG. 1.
FIG. 3 is a schematic structural diagram of a circuit board.
FIG. 4 is a schematic structural diagram of a display screen and a connector.
FIG. 5 is a sectional view of a tangent plane in an AA' direction in FIG. 1.
FIG. 6 is a sectional view of a tangent plane in a BB' direction in FIG. 1.

Reference numerals in the figures: 100-display module; 110-housing; 111-connection port; 112-mounting groove; 113-air adjustment channel; 120-circuit board; 121-clearance groove; 1211-first snap-fit structure; 122-third electrical connection structure; 130-display screen; 140-connector; 141-second electrical connection structure; 142-clamping space; 1421-installation opening; and 1422-second snap-fit structure.

### DETAILED DESCRIPTION

The present disclosure will be further described in detail below with reference to specific embodiments and accompanying drawings. Similar elements in different embodiments are labeled with associated similar element labels. In the following embodiments, more details are described to facilitate clearer understanding of the present disclosure. However, those skilled in the art can readily recognize that some of the features can be omitted in different cases, or can be replaced by other elements, materials, and methods. In some cases, some operations related to the present disclosure are not shown or described in the specification, with the aim of preventing the important part of the present disclosure from being overwhelmed by excessive description, and for those skilled in the art, it is unnecessary to describe these related operations in detail, and they can gain a thorough understanding of the related operations according to the description in the specification and the general technical knowledge in the field.

In addition, the features, operations, or characteristics described in the specification can be combined in any suitable manner to form various embodiments. Operation steps involved in each embodiment can also be sequentially exchanged or adjusted in a manner obvious to those skilled in the art. Therefore, the specification and drawings are merely for clear description of an embodiment, and are not intended to be a necessary composition and/or sequence.

The serial numbers assigned to the components herein, such as "first", "second", are only used to distinguish the described objects, and do not have any sequence or technical meaning. The terms "connection" and "coupling" mentioned herein include direct and indirect connection (coupling), unless otherwise specified.

In the prior art, connecting a display screen 130 to a circuit board 120 via an FPC cable is cumbersome in operation steps, which easily causes the problem of improper assembly. For connection by soldering, the problem of pseudo soldering is likely to occur during processing. When either of the two connection methods is adopted, the problem of poor contact between the display screen 130 and the circuit board 120 occurs, which further leads to functional failure of the display screen 130 or the circuit board 120. A connector 140 provided in the present disclosure is installed in a simple manner, and has a simple electrical connection structure thereon, which firmly connects the circuit board 120 and the display screen 130, and prevents poor contact therebetween, and functional failure.

### Embodiment 1

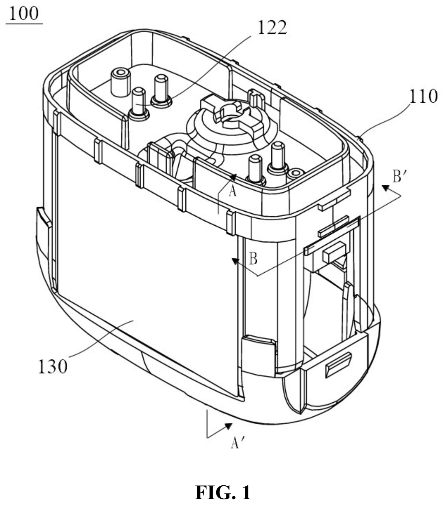

The present disclosure provides a display module 100 of an atomization device, and with reference to FIGS. 1 to 6, the display module 100 includes a housing 110, a circuit board 120, a display screen 130, and a connector 140.

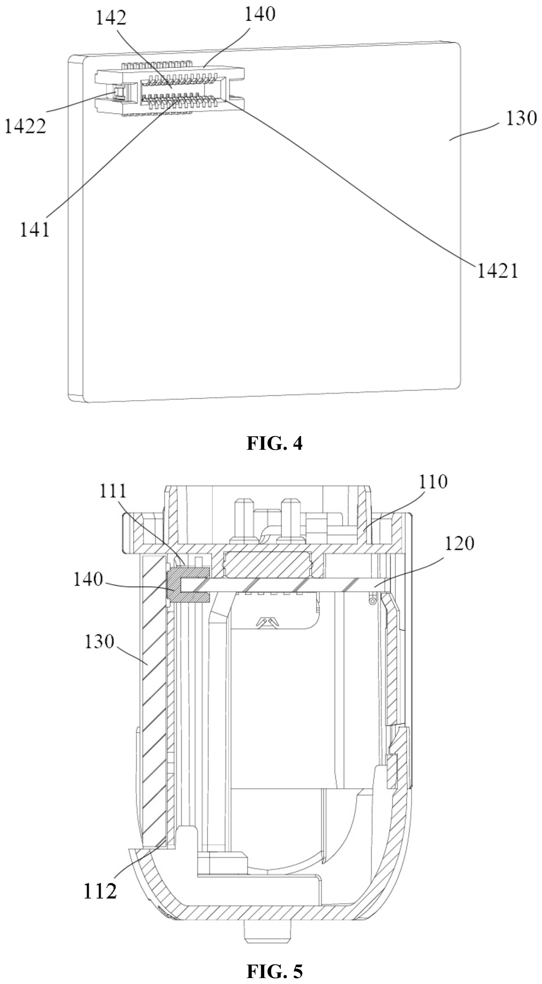

With reference to FIGS. 4 and 5, the circuit board 120 is disposed in the housing 110, and the circuit board 120 is provided with a first electrical connection structure (not shown in the figures). The display screen 130 is disposed inside the housing 110 or outside the housing 110. The connector 140 is disposed on the display screen 130 and electrically connected to the display screen 130. The connector 140 has a second electrical connection structure 141, and the second electrical connection structure 141 is detachably connected to the first electrical connection structure.

In the present disclosure, the first electrical connection structure is disposed on the circuit board 120, the connector 140 is disposed on the display screen 130, the second electrical connection structure 141 is disposed on the connector 140, and an electrical connection between the display screen 130 and the circuit board 120 is achieved through a detachable connection between the second electrical connection structure 141 and the first electrical connection structure. The connector 140 is structurally simple and easy to install, and is directly disposed on the display screen 130, which reduces operation steps and costs.

As shown in FIGS. 4 and 5, the connector 140 is provided with a clamping space 142 having an installation opening 1421, the second electrical connection structure 141 is disposed in the clamping space 142, and a portion of the circuit board 120 provided with the first electrical connection structure is assembled into the clamping space 142 through the installation opening 1421, such that the second electrical connection structure 141 is electrically connected to the first electrical connection structure, and the second electrical connection structure 141 elastically abuts against the first electrical connection structure to clamp the circuit board 120 in the clamping space 142.

The clamping space 142 is disposed on the connector 140, the second electrical connection structure 141 is disposed in the clamping space 142, and the second electrical connection structure 141 elastically abuts against the first electrical connection structure, such that the circuit board 120 is clamped in the clamping space 142, which achieves an electrical connection between the circuit board 120 and the display screen 130, firmly connects the circuit board 120 and the display screen 130, and prevents poor contact between the circuit board 120 and the display screen 130.

With reference to FIG. 4, the installation opening 1421 is disposed on a side of the connector 140 facing away from the display screen 130, and the circuit board 120 is arranged perpendicular to the display screen 130.

The installation opening 1421 is disposed on the side of the connector 140 facing away from the display screen 130, and the circuit board 120 is directly pushed into the clamping space 142 after aligning with the installation opening 1421, which facilitates disassembly and installation. The circuit board 120 is arranged perpendicular to the display screen 130, which facilitates the subsequent arrangement of other structures.

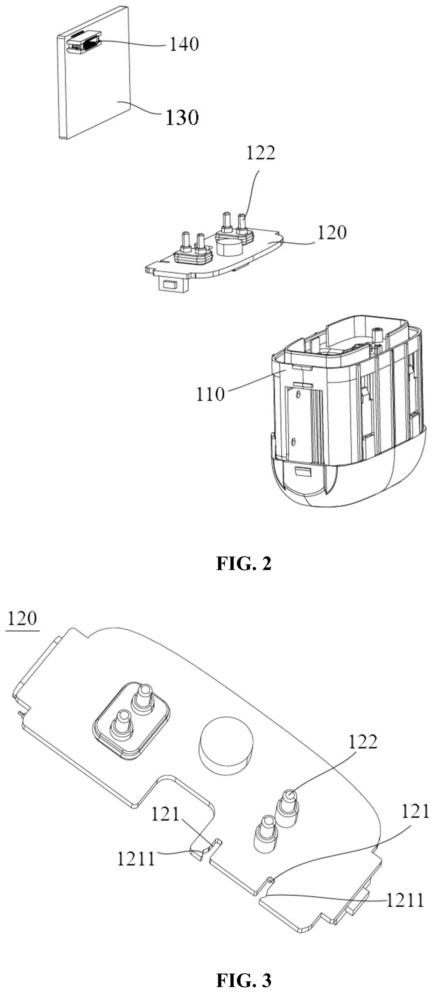

With reference to FIG. 3, the circuit board 120 is provided with a clearance groove 121, a side wall of the clearance groove 121 is provided with a first snap-fit structure 1211, and as shown in FIG. 4, an outer side wall of the clamping space 142 is provided with a second snap-fit structure 1422, a side wall of the clamping space 142 extends into the clearance groove 121, and the second snap-fit structure 1422 cooperates with the first snap-fit structure 1211 to further fixedly connect the circuit board 120 and the display screen 130.

The circuit board 120 is initially clamped in the clamping space 142 through the elastic abutment of the second electrical connection structure 141 against the first electrical connection structure, the first snap-fit structure 1211 is disposed in the clearance groove of the present disclosure, the second snap-fit structure 1422 is disposed on the outer side wall of the clamping space 142, and snap-fit engagement between the first snap-fit structure 1211 and the second snap-fit structure 1422 further achieves a fixed connection between the circuit board 120 and the connector 140, thereby ensuring a firmer connection between the circuit board 120 and the connector 140, and preventing poor contact between the circuit board 120 and the display screen 130.

With reference to FIGS. 3 and 4, the first snap-fit structure 1211 includes a snap-fit groove, and the second snap-fit structure 1422 includes a snap-fit clasp, where the snap-fit clasp has elasticity, thereby allowing the snap-fit clasp to easily extend into or disengage from the snap-fit groove.

The arrangement of the elastic snap-fit clasp enables the snap-fit clasp to bypass a side wall of the snap-fit groove when the circuit board 120 and the display screen 130 need to be disassembled, thereby achieving disengagement from the snap-fit groove. When the circuit board 120 and the display screen 130 need to be installed, the snap-fit clasp easily extends into the snap-fit groove by clearing the side wall of the snap-fit groove.

With reference to FIG. 3, in this embodiment, two clearance grooves 121 are formed, one first snap-fit structure 1211 is disposed in either of the clearance grooves 121, and the second snap-fit structures 1422 are arranged in one-to-one correspondence with the first snap-fit structures 1211.

Compared to arrangement of one clearance groove 121, arrangement of two clearance grooves 121 on the circuit board 120 enables to fix the circuit board 120 on the connector 140 more stably.

With reference to FIG. 4, elastic second electrical connection structures 141 are respectively disposed on opposite inner sides of the clamping space 142, and the second electrical connection structures 141 elastically abut against the first electrical connection structures to clamp and fix the circuit board 120 in the clamping space 142. More specifically, a plurality of the second electrical connection structures 141 are disposed on either side of the clamping space 142. The first electrical connection structures are arranged in one-to-one correspondence with the second electrical connection structures 141.

The elastic second electrical connection structures 141 are oppositely arranged in the clamping space 142, such that the two second electrical connection structures 141 cooperate to achieve an effect of clamping the circuit board 120.

More specifically, from a perspective shown in FIG. 4, an upper wall and a lower wall of the clamping space 142 have inclined slopes at the installation opening 1421 to facilitate insertion of the circuit board 120 into the clamping space 142.

With reference to FIG. 5, the display screen 130 is disposed on an outer side wall of the housing 110, the outer side wall of the housing 110 is provided with a connection port 111 penetrating through the outer side wall of the housing 110, and the connector 140 is electrically connected to the circuit board 120 through the connection port 111.

The display screen 130 is disposed on the outer side wall of the housing 110, which facilitates external viewing of content displayed on the display screen 130 after assembly of the atomization device; and the circuit board 120 is fixedly disposed in the housing 110, the connector 140 passes through the connection port 111 and connects both the circuit board 120 and the display screen 130, and the display screen 130 is installed more stably through the fixed installation of the circuit board 120.

With reference to FIG. 5, a mounting groove 112 is concavely disposed on the outer side wall of the housing 110, and the display screen 130 is disposed in the mounting groove 112.

Due to the recessed design of the mounting groove 112, the display screen 130 is mounted in the mounting groove 112, which saves space for the entire atomization device.

In this embodiment, an adhesive layer (not shown in the figures) is disposed on a portion of the outer side wall of the housing 110, and the adhesive layer is located between the mounting groove 112 and the display screen 130 and configured to adhesively fix the display screen 130. More specifically, the adhesive layer is disposed in the mounting groove 112 and located between the mounting groove 112 and the display screen 130 and configured to adhesively fix the display screen 130.

Compared with the above connector 140, the display screen 130 has a relatively large overall area, and other portions not provided with the connector 140 are prone to shaking during use. Therefore, the adhesive layer is disposed between the mounting groove 112 and the display screen 130 to fix the display screen 130 and prevent shaking of the display screen 130 so as to ensure the subsequent display effect.

With reference to FIGS. 1 to 3, the circuit board 120 is further provided with a third electrical connection structure 122, and an end of the third electrical connection structure 122 away from the circuit board 120 passes through the housing 110 and is configured to electrically connect to an atomizer of the atomization device, such that the circuit board 120 controls an operating state of the atomizer, and the circuit board 120 controls the display screen 130 to display a liquid volume and operating state of the atomizer. As mentioned above, vertical arrangement of the circuit board 120 and the display screen 130 facilitates an electrical connection with the atomizer at a position of the third electrical connection structure 122 after the third electrical connection structure 122 is installed.

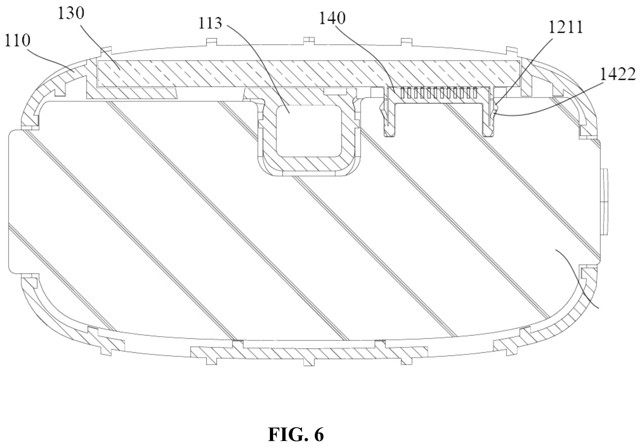

With reference to FIG. 6, an air adjustment channel 113 is further disposed in the housing 110, the air adjustment channel 113 is configured to communicate with the air adjustment channel 113 of the atomizer, an air adjustment opening (not shown in the figures) is formed at a bottom of the housing 110, an air adjustment valve (not shown in the figures) is disposed at the air adjustment opening, and the air adjustment valve is configured to adjust a size of the air adjustment opening, control a volume of air intake into the air adjustment channel 113, and further adjust the air intake volume of the atomization device.

### Embodiment 2

The present disclosure provides a display module 100 of an atomization device, and with reference to FIGS. 1 to 6, the display module 100 includes a housing 110, a circuit board 120, a display screen 130, and a connector 140.

With reference to FIGS. 4 and 5, the circuit board 120 is disposed in the housing 110, and the circuit board 120 is provided with a first electrical connection structure (not shown in the figures). The display screen 130 is disposed inside the housing 110 or outside the housing 110. The connector 140 is disposed on the display screen 130 and electrically connected to the display screen 130. The connector 140 has a second electrical connection structure 141, and the second electrical connection structure 141 is detachably connected to the first electrical connection structure.

In the present disclosure, the first electrical connection structure is disposed on the circuit board 120, the connector 140 is disposed on the display screen 130, the second electrical connection structure 141 is disposed on the connector 140, and an electrical connection between the display screen 130 and the circuit board 120 is achieved through a detachable connection between the second electrical connection structure 141 and the first electrical connection structure. The connector 140 is structurally simple and easy to install, and is directly disposed on the display screen 130, which reduces operation steps and costs.

The connector 140 is provided with a clamping space 142 having an installation opening 1421, the second electrical connection structure 141 is disposed in the clamping space 142, and a portion of the circuit board 120 provided with the first electrical connection structure is assembled into the clamping space 142 through the installation opening 1421, such that the second electrical connection structure 141 is electrically connected to the first electrical connection structure, and the second electrical connection structure 141 elastically abuts against the first electrical connection structure to clamp the circuit board 120 in the clamping space 142.

As shown in FIGS. 4 and 5, the clamping space 142 is disposed on the connector 140, the second electrical connection structure 141 is disposed in the clamping space 142, and the second electrical connection structure 141 elastically abuts against the first electrical connection structure, such that the circuit board 120 is clamped in the clamping space 142, which achieves an electrical connection between the circuit board 120 and the display screen 130, firmly connects the circuit board 120 and the display screen 130, and prevents poor contact between the circuit board 120 and the display screen 130.

With reference to FIG. 4, the installation opening 1421 is disposed on a side of the connector 140 facing away from the display screen 130, and the circuit board 120 is arranged perpendicular to the display screen 130.

The installation opening 1421 is disposed on the side of the connector 140 facing away from the display screen 130, and the circuit board 120 is directly pushed into the clamping space 142 after aligning with the installation opening 1421, which facilitates disassembly and installation. The circuit board 120 is arranged perpendicular to the display screen 130, which facilitates the subsequent arrangement of other structures.

With reference to FIG. 3, the circuit board 120 is provided with a clearance groove 121, a side wall of the clearance groove 121 is provided with a first snap-fit structure 1211, and an outer side wall of the clamping space 142 is provided with a second snap-fit structure 1422, a side wall of the clamping space 142 extends into the clearance groove 121, and the second snap-fit structure 1422 cooperates with the first snap-fit structure 1211 to further fixedly connect the circuit board 120 and the display screen 130.

The circuit board 120 is initially clamped in the clamping space 142 through the elastic abutment of the second electrical connection structure 141 against the first electrical connection structure, the first snap-fit structure 1211 is disposed in the clearance groove of the present disclosure, the second snap-fit structure 1422 is disposed on the outer side wall of the clamping space 142, and snap-fit engagement between the first snap-fit structure 1211 and the second snap-fit structure 1422 further achieves a fixed connection between the circuit board 120 and the connector 140, thereby ensuring a firmer connection between the circuit board 120 and the connector 140, and preventing poor contact between the circuit board 120 and the display screen 130.

In this embodiment, the second snap-fit structure 1422 includes a snap-fit groove, and the first snap-fit structure 1211 includes a snap-fit clasp, where the snap-fit clasp has elasticity, thereby allowing the snap-fit clasp to easily extend into or disengage from the snap-fit groove.

The arrangement of the elastic snap-fit clasp enables the snap-fit clasp to bypass a side wall of the snap-fit groove when the circuit board 120 and the display screen 130 need to be disassembled, thereby achieving disengagement from the snap-fit groove. When the circuit board 120 and the display screen 130 need to be installed, the snap-fit clasp easily extends into the snap-fit groove by clearing the side wall of the snap-fit groove.

With reference to FIG. 3, in this embodiment, two clearance grooves 121 are formed, one first snap-fit structure 1211 is disposed in either of the clearance grooves 121, and the second snap-fit structures 1422 are arranged in one-to-one correspondence with the first snap-fit structures 1211.

Compared to arrangement of one clearance groove 121, arrangement of two clearance grooves 121 on the circuit board 120 enables to fix the circuit board 120 on the connector 140 more stably.

With reference to FIG. 4, elastic second electrical connection structures 141 are respectively disposed on opposite inner sides of the clamping space 142, and the second electrical connection structures 141 elastically abut against the first electrical connection structures to clamp and fix the circuit board 120 in the clamping space 142. More specifically, a plurality of the second electrical connection structures 141 are disposed on either side of the clamping space 142. The first electrical connection structures are arranged in one-to-one correspondence with the second electrical connection structures 141.

The elastic second electrical connection structures 141 are oppositely arranged in the clamping space 142, such that the two second electrical connection structures 141 cooperate to achieve an effect of clamping the circuit board 120.

More specifically, from a perspective shown in FIG. 4, an upper wall and a lower wall of the clamping space 142 have inclined slopes at the installation opening 1421 to facilitate insertion of the circuit board 120 into the clamping space 142.

With reference to FIG. 5, the display screen 130 is disposed on an outer side wall of the housing 110, the outer side wall of the housing 110 is provided with a connection port 111 penetrating through the outer side wall of the housing 110, and the connector 140 is electrically connected to the circuit board 120 through the connection port 111.

The display screen 130 is disposed on the outer side wall of the housing 110, which facilitates external viewing of content displayed on the display screen 130 after assembly of the atomization device; and the circuit board 120 is fixedly disposed in the housing 110, the connector 140 passes through the connection port 111 and connects both the circuit board 120 and the display screen 130, and the display screen 130 is installed more stably through the fixed installation of the circuit board 120.

With reference to FIG. 5, a mounting groove 112 is concavely disposed on the outer side wall of the housing 110, and the display screen 130 is disposed in the mounting groove 112.

Due to the recessed design of the mounting groove 112, the display screen 130 is mounted in the mounting groove 112, which saves space for the entire atomization device.

In this embodiment, an adhesive layer (not shown in the figures) is disposed on a portion of the outer side wall of the housing 110, and the adhesive layer is located between the mounting groove 112 and the display screen 130 and configured to adhesively fix the display screen 130. More specifically, the adhesive layer is disposed in the mounting groove 112 and located between the mounting groove 112 and the display screen 130 and configured to adhesively fix the display screen 130.

Compared with the above connector 140, the display screen 130 has a relatively large overall area, and other portions not provided with the connector 140 are prone to shaking during use. Therefore, the adhesive layer is disposed between the mounting groove 112 and the display screen 130 to fix the display screen 130 and prevent shaking of the display screen 130 so as to ensure the subsequent display effect.

With reference to FIGS. 1 to 3, the circuit board 120 is further provided with a third electrical connection structure 122, and an end of the third electrical connection structure 122 away from the circuit board 120 passes through the housing 110 and is configured to electrically connect to an atomizer of the atomization device, such that the circuit board 120 controls an operating state of the atomizer, and the circuit board 120 controls the display screen 130 to display a liquid volume and operating state of the atomizer. As mentioned above, vertical arrangement of the circuit board 120 and the display screen 130 facilitates an electrical connection with the atomizer at a position of the third electrical connection structure 122 after the third electrical connection structure 122 is installed.

With reference to FIG. 6, an air adjustment channel 113 is further disposed in the housing 110, the air adjustment channel 113 is configured to communicate with the air adjustment channel 113 of the atomizer, an air adjustment opening (not shown in the figures) is formed at a bottom of the housing 110, an air adjustment valve (not shown in the figures) is disposed at the air adjustment opening, and the air adjustment valve is configured to adjust a size of the air adjustment opening, control a volume of air intake into the air adjustment channel 113, and further adjust the air intake volume of the atomization device.

### Embodiment 3

In this embodiment, an atomization device is provided, and the atomization device includes an atomizer (not shown in the figures), a power supply (not shown in the figures), and the display module 100 in Embodiment 1 or 2, where the power supply is disposed in the housing 110, the display module 100 is electrically connected to the power supply, the atomizer is electrically connected to the display module 100, and the display screen 130 displays a battery level of the power supply, and a liquid volume and operating state of the atomizer.

The above specific examples are applied to describe the present disclosure, are only intended to help understand the present disclosure, and are not intended to limit the present disclosure. For those skilled in the art to which the present disclosure belongs, several simple deductions, modifications, or substitutions may also be made according to the ideas presented in the present disclosure.

## Claims

1. A display module (100) of an atomization device, comprising:
a housing (110);
a circuit board (120) disposed in the housing (110), wherein the circuit board (120) is provided with a first electrical connection structure;
a display screen (130) disposed inside the housing (110) or outside the housing (110); and
a connector (140) disposed on the display screen (130) and electrically connected to the display screen (130), wherein the connector (140) has a second electrical connection structure (141), and the second electrical connection structure (141) is detachably connected to the first electrical connection structure.

2. The display module (100) according to claim 1, wherein the connector (140) is provided with a clamping space (142) having an installation opening (1421), the second electrical connection structure (141) is disposed in the clamping space (142), and a portion of the circuit board (120) provided with the first electrical connection structure is assembled into the clamping space (142) through the installation opening (1421), such that the second electrical connection structure (141) is electrically connected to the first electrical connection structure, and the second electrical connection structure (141) elastically abuts against the first electrical connection structure to clamp the circuit board (120) in the clamping space (142).

3. The display module (100) according to claim 2, wherein the installation opening (1421) is disposed on a side of the connector (140) facing away from the display screen (130), and the circuit board (120) is arranged perpendicular to the display screen (130).

4. The display module (100) according to claim 2, wherein the circuit board (120) is provided with a clearance groove (121), a side wall of the clearance groove (121) is provided with a first snap-fit structure (1211), an outer side wall of the clamping space (142) is provided with a second snap-fit structure (1422), a side wall of the clamping space (142) extends into the clearance groove (121), and the second snap-fit structure (1422) cooperates with the first snap-fit structure (1211) to further fixedly connect the circuit board (120) and the display screen (130).

5. The display module (100) according to claim 4, wherein the first snap-fit structure (1211) comprises a snap-fit groove, and the second snap-fit structure (1422) comprises a snap-fit clasp, wherein the snap-fit clasp has elasticity, thereby allowing the snap-fit clasp to easily extend into or disengage from the snap-fit groove; and
alternatively, the second snap-fit structure (1422) comprises a snap-fit groove, and the first snap-fit structure (1211) comprises a snap-fit clasp, wherein the snap-fit clasp has elasticity, thereby allowing the snap-fit clasp to easily extend into or disengage from the snap-fit groove.

6. The display module (100) according to claim 4, wherein at least two clearance groove (121)s are formed, at least one first snap-fit structure (1211) is disposed in each of the clearance groove (121)s, and the second snap-fit structure (1422)s are arranged in one-to-one correspondence with the first snap-fit structure (1211)s.

7. The display module (100) according to claim 2, wherein elastic second electrical connection structure (141)s are respectively disposed on opposite inner sides of the clamping space (142), and the second electrical connection structure (141)s elastically abut against the first electrical connection structures to clamp and fix the circuit board (120) in the clamping space (142).

8. The display module (100) according to claim 2, wherein the display screen (130) is disposed on an outer side wall of the housing (110), the outer side wall of the housing (110) is provided with a connection port (111) penetrating through the outer side wall of the housing (110), and the connector (140) is electrically connected to the circuit board (120) through the connection port (111).

9. The display module (100) according to claim 8, wherein a mounting groove(112) is concavely disposed on the outer side wall of the housing (110), and the display screen (130) is disposed in the mounting groove(112).

10. The display module (100) according to claim 8, wherein an adhesive layer is disposed on a portion of the outer side wall of the housing (110), and the adhesive layer is located between the mounting groove(112) and the display screen (130) and configured to adhesively fix the display screen (130).

11. An atomization device, comprising an atomizer and the display module (100) according to any one of claims 1-10, wherein the atomizer is electrically connected to the display module (100), and the display module (100) is configured to display a liquid volume and operating state of the atomizer.
